# EUROPÄISCHE PATENTSCHRIFT

(11) **EP 0 981 162 B1**
(45) Veröffentlichungstag und Bekanntmachung des Hinweises auf die Patenterteilung: **07.03.2007**
(21) Anmeldenummer: 98115621.9
(22) Anmeldetag: 19.08.1998
(51) Int. Cl.: H01L 23/528

(54) **Halbleiterchip mit Oberflächenabdeckung gegen optische Untersuchung der Schaltungsstruktur**
Semiconductor chip with surface cover against optical inspection of the circuit structure
Puce semi-conductrice avec une couverture de surface contre l'inspection optique de structure de circuit

(43) Veröffentlichungstag der Anmeldung: 23.02.2000
(73) Patentinhaber: Infineon Technologies AG, 80506 München (DE)
(72) Erfinder: Allinger, Robert, 82008 Unterhaching (DE); Pockrandt, Wolfgang, 85293 Reichertshausen (DE)
(74) Vertreter: Epping - Hermann - Fischer

(56) Entgegenhaltungen:
- EP-A- 0 378 306
- EP-A- 0 764 985
- WO-A-96/16445

## Beschreibung

Die Erfindung betrifft einen Halbleiterchip mit in zumindest einer Schicht eines Halbleitersubstrats realisierten, in zumindest einer Gruppe angeordneten Schaltungen und mit in zumindest einer Verdrahtungsebene über den Schaltungen verlaufenden Versorgungs- und Signalleitungen.

Ein solcher Halbleiterchip ist aus der EP 0 378 306 A2 bekannt. Beim dortigen Halbleiterchip ist eine erste Schaltungsgruppe in einem gesicherten Bereich und eine zweite Schaltungsgruppe in einem nicht gesicherten Bereich angeordnet. Die Sicherung des ersten Bereiches erfolgt beim bekannten Halbleiterchip durch eine leitende Schicht, die über der Verdrahtungsebene der ersten Schaltungsgruppe angeordnet ist. Diese leitende Schicht ist mit der Schaltungsgruppe elektrisch verbunden, wobei eine ordnungsgemäße Funktion dieser Schaltungsgruppe nur bei intakter Schicht gegeben ist.

Die erste Schaltungsgruppe umfaßt hier einen Mikroprozessor sowie zugehörige Peripherieschaltungen wie Speicher und eine Transferlogikschaltung. In den Speichern können insbesondere geheime Informationen stehen. Es ist auch denkbar, daß der Mikroprozessor eine spezielle Struktur hat, die für sicherheitsrelevante Funktionen besonders gut geeignet ist. Durch die leitende Schicht, deren Unversehrtheit ständig überprüft wird, wird ein Ausspähen mittels beispielsweise eines Rasterelektronmikroskops während des Betriebs der Schaltung verhindert.

Allerdings erfordert diese leitende Schicht einen weiteren Verfahrenschritt bei der Herstellung des Halbleiterchips. Außerdem sind entsprechenende Auswerteschaltungen für die Detektion der Unversehrtheit der leitenden Schicht nötig.

In der EP 0764985 A2 ist eine integrierte elektronische Schaltung beschrieben, die dadurch gegen Reverse-Engineering geschützt ist, dass eine Anordnung einer Vielzahl von Transistoren gleicher Größe und Geometrie mit einem gleichartigen Layout der elektrischen Verbindungen über dotierte Bereiche im Halbleiterkörper versehen ist. Die elektrische Verschaltung wird zusätzlich dadurch kaschiert, dass über der Transistoranordnung metallische Leiter in einem gleichförmigen Muster angeordnet sind. Es war aus dieser Schrift bekannt, einen Halbleiterchip mit in zumindest einer Schicht eines Halbleitersubstrats realisierten und in zumindest einer Gruppe angeordneten Schaltungen und mit in zumindest einer Verdrahtungsebene über den Schaltungen verlaufenden Versorgungs- und Signalleitungen zu versehen. Die oberseitigen Versorgungs- und Signalleitungen sind hier jedoch nur als Attrappe vorgesehen.

Aufgabe der Erfindung ist es, einen Halbleiterchip anzugeben, der gegen ein Ausspähen sicherheitsrelevanter Schaltungsteile mittels eines Rasterelektronenmikroskops geschützt ist.

Die Aufgabe wird dadurch gelöst, daß bei einem gattungsgemäßen Halbleiterchip in zumindest einer Verdrahtungsebene über zumindest einer Schaltungsgruppe die Versorgungs- und Signalleitungen eine möglichst große Breite haben, so dass der Abstand zwischen Leitungen entlang dem größten Teil jeweiliger Leitungslängen minimal oder maximal doppelt so groß wie minimal ist und so dass alle Leitungen soweit verbreitert sind, dass eine optische Untersuchung der Schaltungsstruktur unter der Verdrahtungsebene nicht mehr möglich ist. Bei einer vorteilhaften Ausbildung entspricht der Abstand zwischen zwei Leitungen im wesentlichen dem gemäß dem jeweiligen Stand einer Technologiegeneration minimal realisierbaren Abstand.

Im wesentlichen bedeutet hierbei, daß der Abstand zwischen Leitungen entlang dem größten Teil jeweiliger Leitungslängen minimal oder maximal doppelt so groß wie minimal ist. Durch diesen geringen Abstand ist einerseits die Chipoberfläche fast völlig durch die ohnehin nötige leitende Verdrahtungsschicht abgedeckt und ist vor optischer und auch elektronenoptischer Untersuchung geschützt. Andererseits würde eine großflächige Entfernung der Leitungen, um eine optische Oberflächenuntersuchung vornehmen zu können, dazu führen, daß die Schaltungen nicht mehr funktionieren, ohne daß weitere Detektorschaltungen nötig wären.

Eine nur punktuelle Entfernung der Leitungen, beispielsweise um Schaltungsteile abzutrennen, gelingt nicht, da durch den geringen Abstand eine Verschweißung benachbarter Leitungen erfolgen würde.

Die Verbreiterung der Leitungen erfolgt beim Entwurf der Topologie des Halbleiterchips. Hierbei werden zunächst die Masseleitungen so breit als möglich gestaltet, um eine möglichst gute kapazitive Ankoppelung der Masse zum Substrat zu gewährleisten sowie eine niederohmige Spannungsversorgung bei minimaler Verkoppelung der übrigen Signalleitungen untereinander zu gewährleisten. Im nächsten Schritt werden die Versorgungsspannungsleitungen verbreitert. Erst zum Schluß werden die Signalleitungen verbreitert, um eine möglichst geringe Verkoppelung der Signalleitungen untereinander sicherzustellen.

Die erfindungsgemäße Verbreiterung der Leitungen in zumindest einer Verdrahtungsebene erfolgt zumindest über sicherheitskritischen Schaltungsteilen wie Speicher für geheime Codes oder spezielle Verschlüsselungsschaltungen. Es ist jedoch von Vorteil, die Leitungen der gesamten Oberfläche zu verbreitern, um einen möglichen Angreifer keinen möglichen Hinweis zu geben, wo sicherheitsrelevante Schaltungsteile liegen.

Falls mehrere Verdrahtungsebenen existieren ist es möglich, verschiedene Schaltungsgruppen in unterschiedlichen Verdrahtungsebenen abzudecken, wobei hier auch Abdeckungsüberlappungen vorkommen können. Außerdem ist es bei mehreren Verdrahtungsebenen möglich, mehrere komplette Abdeckungen ohne Zusatzaufwand vorzusehen.

Die Erfindung wird nachfolgend an einem Ausführungsbeispiel mit Hilfe von Figuren näher erläutert.

Dabei zeigen:
- Figur 1: eine prinzipielle Querschnittsdarstellung mit einer Schaltungs- und Verdrahtungsebene eines Halbleiterchips,
- Figur 2: einen Ausschnitt aus einer Verdrahtungsebene gemäß dem Stand der Technik und
- Figur 3: denselben Ausschnitt einer Verdrahtungsebene gemäß der Erfindung.

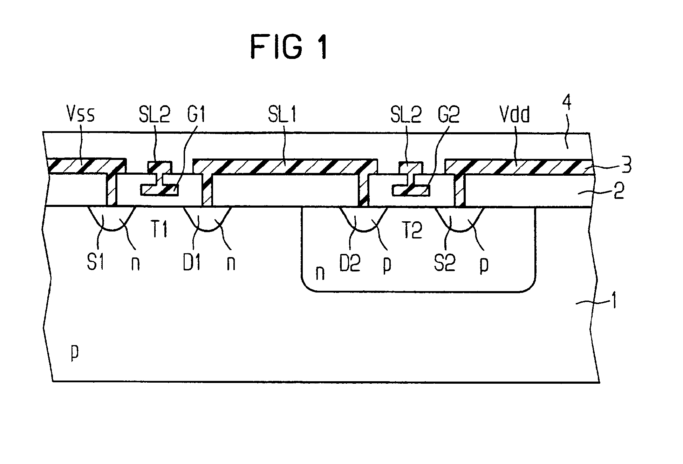

Die Querschnittsdarstellung gemäß Figur 1 zeigt ein p-leitendes Halbleitersubstrat 1 in dem als Schaltungsbeispiel ein CMOS-Inverter realisiert ist. Dieser ist mit einem n-Kanal-Transistor T1 und einem p-Kanal-Transistor T2 gebildet.

Über der aktiven Schicht des Halbleitersubstrats 1 ist eine isolierende Schicht 2, die meistens aus Siliziumoxid gebildet ist, angeordnet. Über dieser Isolierschicht 2 ist eine Verdrahtungsebene 3 angeordnet. Diese besteht aus Masseleitungen Vss, Versorgungsspannungsleitungen Vdd sowie Signalleitungen SL1, SL2. Zur Realisierung des CMOS-Inverters ist der Sourcebereich S1 des n-Kanal-Transistors T1 durch die Isolierschicht 2 hindurch mit der Masseleitung Vss verbunden. Sowohl der Drainbereich D1 des n-Kanal-Transistors T1 als auch der Drainbereich D2 des p-Kanal-Transistors T2 sind durch die Isolierschicht 2 hindurch mit der Signalleitung SL1 verbunden. Der Sourcebereich S2 des p-Kanal-Transistors T2 ist mit der Versorgungsspannungsleitung Vdd verbunden. In der Isolierschicht 2 sind Gateelektroden G1 und G2 angeordnet, die mit einer Signalleitung SL2 verbunden sind. Über der Verdrahtungsebene 3 ist überlicherweise eine weitere Schutzschicht in Form einer Passivierungsschicht 4 angeordnet. In Figur 1 sind zwar nur eine aktive Schicht und eine Verdrahtungsebene 3 gezeigt, die Erfindung läßt sich jedoch ebenso bei mehreren aktiven Schichten und/oder mehreren Verdrahtungsebenen realisieren.

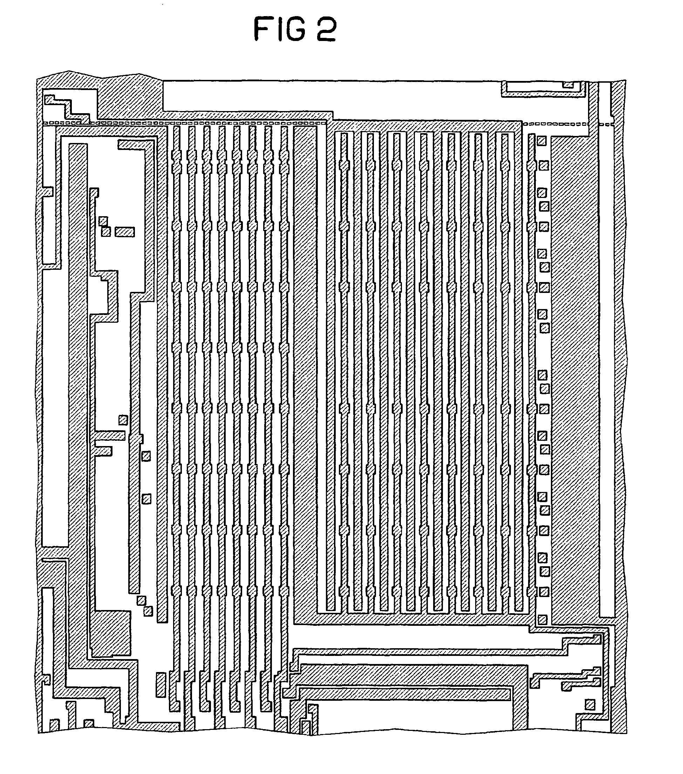

In Figur 2 ist ein Ausschnitt aus einer Verdrahtungsebene gemäß dem Stand der Technik gezeigt. Wie zu erkennen ist, sind zwischen den Leitungen erhebliche Lücken, so daß unter Umständen die darunterliegende Schaltungsstruktur auf optischem Wege erkundet werden kann.

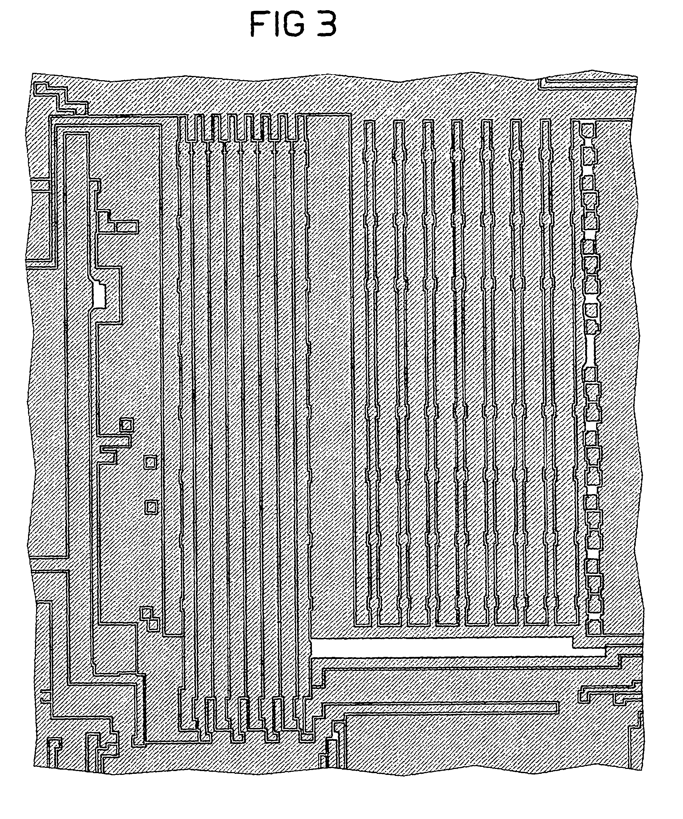

Figur 3 zeigt hingegen eine erfindungsgemäße Verdrahtungsebene, bei der alle Leitungen soweit verbreitert sind, daß sich zwischen ihnen ein gemäß dem jeweiligen Stand einer Technologiegeneration minimal realisierbarer Abstand ergibt. Hierdurch ist zum einen eine optische Untersuchung der Schaltungsstruktur unter der Verdrahtungsebene nicht mehr möglich, zum anderen wird beim Versuch, die Leiter zu entfernen eine Verschweißung einzelner Leiter auftreten, so daß Kurzschlüsse entstehen. Eine vollständige Entfernung der Leiter würde die Funktion der darunterliegenden Schaltung unterbinden.

## Patentansprüche

1. Halbleiterchip mit in zumindest einer Schicht eines Halbleitersubstrats (1) realisierten, in zumindest einer Gruppe angeordneten Schaltungen (T1, T2) und mit in zumindest einer Verdrahtungsebene (3) über den Schaltungen (T1, T2) verlaufenden Versorgungs- und Signalleitungen (Vss, Vdd, SL1, SL2),
**dadurch gekennzeichnet,**
**dass** in zumindest einer Verdrahtungsebene (3) über zumindest einer Schaltungsgruppe die Versorgungs- und Signalleitungen (Vss, Vdd, SL1, SL2) eine möglichst große Breite haben, so dass der Abstand zwischen Leitungen entlang dem größten Teil jeweiliger Leitungslängen minimal oder maximal doppelt so groß wie minimal ist und so dass alle Leitungen soweit verbreitert sind, dass eine optische Untersuchung der Schaltungsstruktur unter der Verdrahtungsebene nicht mehr möglich ist.

2. Halbleiterchip nach Anspruch 1, bei dem
mehrere Verdrahtungsebenen existieren und verschiedene Schaltungsgruppen in unterschiedlichen Verdrahtungsebenen abgedeckt sind.

3. Halbleiterchip nach Anspruch 2, bei dem
mehrere komplette Abdeckungen vorgesehen sind.

4. Halbleiterchip nach einem der Ansprüche 1 bis 3, bei dem
die Verbreiterung der Leitungen in zumindest einer Verdrahtungsebene zumindest über einem Speicher für geheime Codes oder einer speziellen Verschlüsselungsschaltung vorhanden ist.

5. Halbleiterchip nach einem der Ansprüche 1 bis 4, bei dem
die Verbreiterung der Leitungen einem Entwurf der Topologie des Halbleiterchips entspricht, bei dem
zunächst Masseleitungen so breit als möglich gestaltet werden,
im nächsten Schritt die Versorgungsspannungsleitungen verbreitert werden und
zum Schluss die Signalleitungen verbreitert werden.

## Claims

1. Semiconductor chip having circuits (T1, T2) produced in at least one layer of a semiconductor substrate (1) and arranged in at least one group, and having supply and signal lines (Vss, Vdd, SL1, SL2) extending in at least one wiring plane over the circuits (T1, T2), **characterized in that** the supply and signal lines (Vss, Vdd, SL1, SL2) have a width which is as large as possible in at least one wiring plane (3) over at least one circuit group, so that the distance between lines along the majority of the respective line lengths is minimal, or at most twice as great as is minimal, and **in that** all the lines are widened to such an extent that optical inspection of the circuit structure under the wiring plane is no longer possible.

2. Semiconductor chip according to Claim 1, wherein there are a plurality of wiring planes and various circuit groups are covered in different wiring planes.

3. Semiconductor chip according to Claim 2, wherein a plurality of complete coverings are provided.

4. Semiconductor chip according to one of Claims 1 to 3, wherein the widening of the lines in at least one wiring plane is provided at least over a memory for secret codes or a special encryption circuit.

5. Semiconductor chip according to one of Claims 1 to 4, wherein the widening of the lines corresponds to a design of the topology of the semiconductor chip in which
earth lines are first made as wide as possible,
the supply voltage lines are widened in the next step, and
finally the signal lines are widened.

## Revendications

1. Puce semi-conductrice ayant des circuits (T1, T2) réalisés dans au moins une couche d'un substrat semiconducteur (1) et agencés en au moins un groupe et des lignes d'alimentation et de signaux (Vss, Vdd, SL1, SL2) s'étendant dans au moins un plan de câblage (3) au-dessus des circuits (T1, T2),
**caractérisée par le fait que** les lignes d'alimentation et de signaux (Vss, Vdd, SL1, SL2) dans au moins un plan de câblage (3) au-dessus d'au moins un groupe de circuits ont une largeur maximale de telle sorte que la distance entre des lignes le long de la plus grande partie de longueurs de lignes respectives est minimale ou au maximum deux fois plus grande que minimale et de telle sorte que toutes les lignes sont si élargies qu'un examen optique de la structure de circuit sous le plan de câblage n'est plus possible.

2. Puce semi-conductrice selon la revendication 1, telle qu'il existe plusieurs plans de câblage et que différents groupes de circuits sont recouverts dans différents plans de câblage.

3. Puce semi-conductrice selon la revendication 2, telle qu'il est prévu plusieurs recouvrements complets.

4. Puce semi-conductrice selon l'une des revendications 1 à 3, telle que l'élargissement des lignes se trouve dans au moins un plan de câblage au moins au-dessus d'une mémoire pour codes secrets ou au-dessus d'un circuit de cryptage spécial.

5. Puce semi-conductrice selon l'une des revendications 1 à 4, telle que l'élargissement des lignes correspond à un dessin de la topologie de la puce semi-conductrice dans lequel
en premier lieu, des lignes de masse sont conçues aussi larges que possible,
ensuite, les lignes de tension d'alimentation sont élargies, et
enfin les lignes de signaux sont élargies.
